# EUROPEAN PATENT SPECIFICATION

(11) **EP 2 466 381 B1**
(45) Date of publication and mention of the grant of the patent: **19.05.2021**
(21) Application number: 10195444.4
(22) Date of filing: 16.12.2010
(51) Int. Cl.: G03F 7/20

(54) **A processing apparatus for processing a flexographic plate, a method and a computer program product**
Verarbeitungsvorrichtung zum Verarbeiten einer flexografischen Platte, Verfahren und Computerprogrammprodukt
Appareil de traitement permettant de traiter une plaque flexographique, procédé et programme informatique

(43) Date of publication of application: 20.06.2012
(73) Proprietor: Xeikon Prepress N.V., 8900 Ieper (BE)
(72) Inventor: De Rauw, Dirk, 9400 Ninove (BE); Lenssens, Pieter, 9620 Zottegem (BE)
(74) Representative: Arnold & Siedsma

(56) References cited:
- WO-A2-2009/053586
- US-A- 4 618 550
- US-A1- 2004 250 720
- US-A1- 2005 058 948
- US-A1- 2006 016 355
- US-A1- 2010 028 815

## Description

The invention relates to a processing apparatus for processing a flexographic plate, comprising a receiving unit for receiving a flexographic plate including a relief layer containing a photosensitive material, and an optical system for locally exposing the relief layer.

Flexographic plates serve as printing plates in a variety of applications. As an example, flexographic plates can be used for printing patterns on plastic bags, such as bags containing food products. Further, flexographic printing can be applied on relief material, such as labels, card board for packaging products and corrugated (card)board or paper.

Prior to an actual printing phase, a fresh flexographic plate is processed for making a desired relief pattern, including a step of imaging photosensitive material in the relief layer of the plate, using a mask technology, such that said material locally polymerizes. Then, un-polymerized material is removed in a washing / cleaning process, so that the polymerized relief pattern is left behind and protrudes upwardly from a ground layer. The process may include either a water based washing process or a solvent based washing process. During the printing process, the protruding pattern contacts a surface to be printed. The height of the relief pattern structure on the plate serves to selectively pick up ink and transfer it to the material to be printed. The substantial advantages of flexo printing are the flexibility in printing materials and the simplicity and stability of the printing process on less sophisticated printing machines than necessary for the offset printing process.

The optical system of a known processing apparatus may include a UV light source, such as a transluminance lamp, generating a light beam causing the photosensitive material in the relief layer to start a polymerization process upon incidence of said beam. The UV light propagates into the relief layer after transmission through a mask.

The method of processing a flexographic plate includes a relatively large number of steps, leading to aligning problems, so that a loss in resolution and quality arises. Further, in the process of providing a mask, impurities may be encapsulated in the photosensitive material causing optical loss of quality during imaging.

As an alternative to conventional mask technology, it has been proposed to provide a carbon layer on top of the layer to be imaged, and to obtain a pattern in the carbon layer by locally evaporating the carbon using an infrared radiation source.

As a further alternative, it has been proposed to perform the imaging process by executing machine based operations in a conditioned room.

However, both alternatives still involve a relatively large number of steps, and are complex and expensive.

It is noted that patent publication US 2010/028815 A1 discloses a method of making a relief image on a flexographic printing plate wherein highlight dots are formed by conventional UV illumination sources, generating conical structure. It is further noted that patent publication US 4 618 550 A also discloses a method of curing flexographic printing plates using conventional ultraviolet lamps generating conical shaped dot structures.

It is noted that patent publication WO 2009/053586 A2 discloses a method of producing, using laser technology, a relief image arrangement in pyramidal shaped structures. It is further noted that patent publication US 2005/058948 A1 discloses a system for mastering microstructures, wherein a laser beam impinges into a negative photoresist layer, through a substrate that is transparent to the laser beam.

It is an object of the invention to provide a processing apparatus according to the preamble, wherein at least one disadvantage identified above is reduced. In particular, the invention aims at obtaining a processing apparatus wherein the number of steps is reduced. Thereto, according to an aspect of the invention, a processing apparatus according to claim 1 is provided. The optical system includes an illumination system for generating an optical beam and an imaging system for directing the beam towards the relief layer for polymerizing a relief pattern in the layer, the relief pattern being constituted by a multiple number of relief parts upwardly protruding from a ground layer, wherein a protruding relief part includes a top section and a basis section having a supporting section supporting the top section, and a stiffening section extending from the supporting section in a lateral direction.

By directly imaging the beam towards the relief layer to locally initiate the desired polymerization process, the number of processing steps is reduced since no steps are required for providing a mask. As a consequence, the process can be simplified and potentially provides patterns having improved resolution and higher printing quality.

By providing a stiffening section extending from the supporting section in a lateral direction, the stiffness of the pillar shaped relief part is improved, thus better sustaining the washing process and providing a stable and durable high resolution pattern for performing the printing process.

In addition, by arranging the imaging system such that the optical beam is directed towards the relief layer via the ground layer the basis section of the relief part can polymerize to form a firm and stiff basis for the top section of the relief pattern, thus elegantly alleviating the problem how to provide a basis section that has a greater width than a top section. By exposure from the back side, the polymerization process starts at the ground layer, and a three-dimensional basis section of the relief parts can grow upwardly. The height of the basis section can be set by determining the radiation energy at a particular location.

By implementing the illumination system as a laser device, an energetic advantage is obtained. In principle, the optical efficiency of the optical system can be exploited, so that a higher throughput can be obtained. Alternatively, another illumination system type can be applied, e.g. a conventional UV light source.

By combining the application of the laser device with the inventive concept of forming stiffening sections using back side exposure, less processing steps are required, while the resolution quality of the flexographic plates remains at least substantially the same, even though laser beams are mainly parallel and generate in principle pillar shaped relief parts having a fixed width.

The invention also relates to a method for processing a flexographic plate according to claim 6.

Further, the invention relates to a computer program product according to claim 15. A computer program product may comprise a set of computer executable instructions stored on a data carrier, such as a flash memory, a CD or a DVD. The set of computer executable instructions, which allow a programmable computer to carry out the method as defined above, may also be available for downloading from a remote server, for example via the Internet.

Other advantageous embodiments according to the invention are described in the following claims.

By way of example only, embodiments of the present invention will now be described with reference to the accompanying figures in which
Fig. 1 shows a schematic top view of a flexographic plate;
Fig. 2 shows a schematic cross sectional side view of an apparatus according to the invention receiving a flexographic plate;
Fig. 3 shows a schematic cross-sectional side view of a flexographic plate, and
Fig. 4 shows a flow chart of an embodiment of a method according to the invention.

The figures are merely schematic views of preferred embodiments according to the invention. In the figures, the same reference numbers refer to equal or corresponding parts.

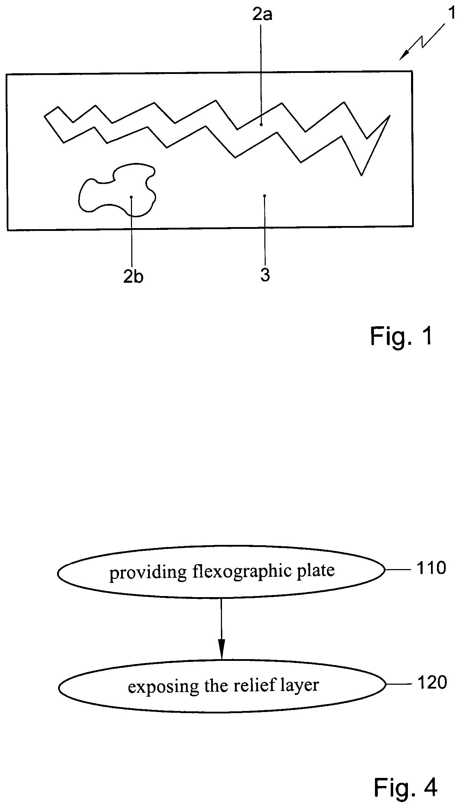

Figure 1 shows a schematic side view of a schematic top view of a flexographic plate 1. The plate is provided with a pre-determined relief pattern 2 being constituted by a multiple number of relief parts 2a,b that protrude upwardly from a ground layer 3. The flexographic plate 1 can be used for printing the relief pattern 2 on a substrate, such as corrugated cardboard.

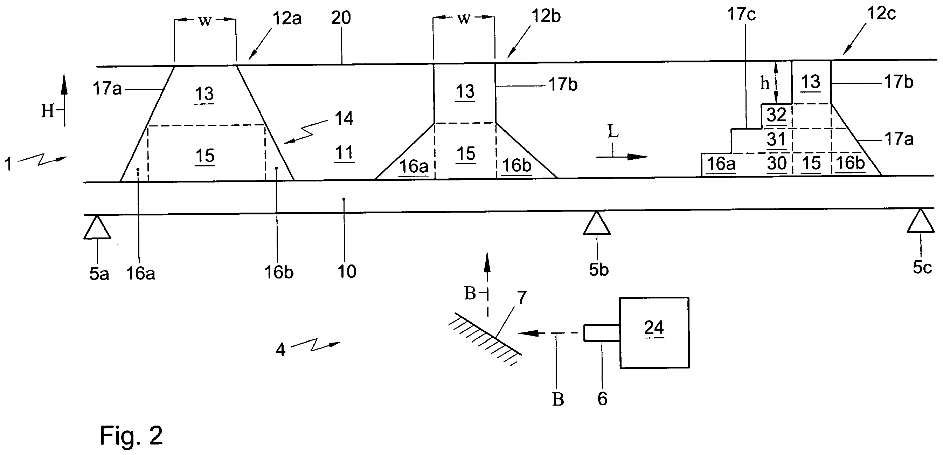

Figure 2 shows a schematic cross sectional side view of an apparatus 4 according to the invention receiving a flexographic plate 1. In the plate 1, a relief pattern 2 has been formed as described below. The apparatus 4 includes a receiving unit 5 for receiving the flexographic plate 1, in the figure schematically shown as a number of receiving sections 5a,b, c. The receiving sections 5 can e.g. be implemented as rollers or vacuum fixation means. As an alternative, the receiving sections are implemented as a table provided with a radiation transparent window for allowing an optical beam to pass. The apparatus 4 further includes an optical system for locally exposing the plate 1. The optical system includes a laser device 6 for generating a laser beam B and an imaging system 7 for directing the beam B towards the plate 1.

The plate 1 includes a ground layer 10 providing a rigid, stable structure for the plate as a whole. The ground layer 10 can be formed by backwardly exposing a photosensitive material layer to radiation causing the material to polymerize. Alternatively, the ground layer 10 is composed of another, relatively stiff material. The plate further includes a relief layer 11 containing a photosensitive material. The photosensitive material is sensitive to radiation of specific wavelength. The relief layer 11 is placed on top of the ground layer 10. Upon radiating the relief layer 11 at pre-defined locations, a polymerization process initiates, thus modifying mechanical properties of the relief layer. More specifically, the relief layer 11 transforms into a rigid structure, forming a desired relief pattern. Figure 2 shows three relief parts 12a, b, c that have been formed by locally radiating the relief layer 11.

The relief parts 12a, b, c protrude upwardly from the ground layer 10. Each of the relief parts 12a, b, c includes a top section 13 and a basis section 14. The basis section 14 has a supporting section 15 supporting the top section 13, and a stiffening section 16a, b extending from the supporting section 15 in a lateral direction L. The top sections can be shaped in different forms, e.g. as a structure having a constant width w in the lateral direction L and a vertical side wall 17b, wherein the top section has a side that is oriented mainly transverse with respect to the ground layer, or as a structure having a decreasing width (in the lateral direction) as a function of increasing distance from the ground layer 10, and having a beveled side surface 17a.

The relief part 12c on the right hand side has a basis section 14 that has been formed in several layers, using a multi-pass process as described below. In the shown relief part 12c, the basis section is composed of three layers 30, 31, 32 formed on top of each other. The upper contour may include a beveled contour, see right hand contour 17a, or a staircase contour, see left hand contour 17c. Apparently, also other contours can be applied, such as a curved contour.

By providing a top section 13 having vertical side walls 17b the printing contact area of the relief part 12c remains substantially equal, thus maintaining a constant printing quality, also if a printing pressure increases. Instead, if the top section 13 has a beveled side wall 17a, see e.g. the left-hand relief part 12a which is not representative of present invention, the size of the contact area may increase when a pressure is applied during printing.

On the other hand, if the height h of the top section having vertical side walls is chosen too large, the top section becomes susceptible to forces causing the top section to bend in a lateral direction, thereby changing the position of the printing area with respect to other relief parts. Then, the printing resolution and printing quality may deteriorate. An optimum top section height h can be selected, depending on e.g. material parameters, providing both a mainly constant printing contact area and a relatively rigid top section.

The stiffening section 16a, b provides a rigid structure to the relief parts 12a, b as the lower side of the basis section 14 has a large area fixed to the ground layer 10. Thus, the relief parts may survive a washing stage and have a minimal lateral deviation when contacting a printing surface.

Prior to processing the flexographic plate 1, a top protective layer may cover the relief layer top surface 20, e.g. for protecting the relief layer 11 against undesired radiation. Further, in principle, a mask pattern can be placed between an irradiating wave and the relief layer 11.

In an embodiment, the laser device 6 is a diode laser generating a laser beam at circa 400-410 nm, such as a laser applied in a blue ray disc system, thus reducing the cost price of the laser device. As an advantage, the photosensitive material can be processed in manufacturing locations that are exposed to daylight via glass. In principle, no special UV shielding measures have to be taken in such in-house locations. Apparently, also another diode laser type, active at another wavelength can be applied, e.g. a diode laser that is used in telecom optical network systems. As an alternative, a mercury light source can be used operating at a wavelength of approximately 365-375 nm. Further, another laser device type can be applied, such as an excimer laser.

The imaging system 7 directs the laser beam B towards the relief layer 11 for polymerizing the relief pattern. Thereto, the imaging system 7 may include a focussing device and/or a reflecting device (as shown in Fig. 2). The optical system may further include a control unit 24 for controlling the laser beam. As an example, the intensity and a time period of directing the beam to a specific location can be controlled, so that the laser beam can be modulated in power and/or in time, thereby regulating the growth of a polymerization process in the relief layer 11.

Further, the imaging system 7 may include a digital micromirror device (DMD) being provided with a two-dimensional array of mirror elements, wherein each of the mirror elements can dynamically be set in a first orientation wherein no radiation is directed to the relief layer 11 or in a second orientation wherein an individual pixel in the relief layer 11 is irradiated. By controlling the orientation of the mirror elements in the two-dimensional array, a corresponding pre-determined two-dimensional pixel array in the relief layer 11 can be irradiated by a multiple number of sub laser beams, and growth of the polymerization process in the pixels can be controlled, thus obtaining an apparatus that is arranged for forming dots in the relief layer in an pre-determined relief pattern.

The character of the laser beam can also be manipulated by changing the focus of the beam. More specifically, the beam focus can be variable, e.g. depending on the location in the height direction H where an actual polymerization process starts.

Alternatively, a mask technology is applied, wherein a mask is located between a single laser beam and the relief layer 11.

The basis section 14 of the relief parts 12 is formed by back exposure, i.e. by the directing the laser beam towards the relief layer 11 via the ground layer 10. The polymerization process starts from the ground layer 10 upwardly, thus forming a solid connection between the relief part 12 and the ground layer 10. As long as the laser beam penetrates the relief layer 11 at a specific location in the ground layer 10, the polymerized section grows in a height direction H towards the top surface 20 of the relief layer 11. The rate of polymerization can be controlled by the intensity or power of the beam, and the height of the relief part can be controlled by the exposure energy being the power integrated over the time period of directing the beam to said location.

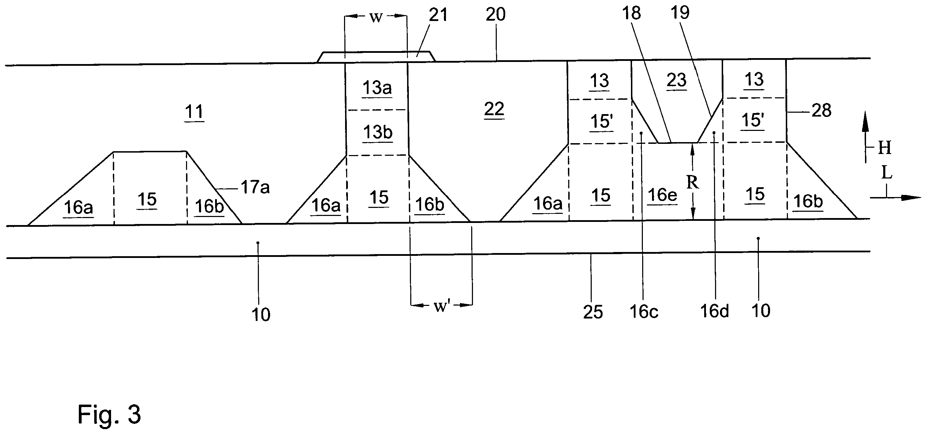

Figure 3 shows a schematic cross-sectional side view of a flexographic plate 1. On the left hand side, a basic section 14 has been formed, including a supporting section 15 and stiffening sections 16a,b. The laser beam B has been controlled such that the upwardly protruding relief part, or at least the basic section 15, 16a,b thereof, has a bevelled side surface 17a.

According to an embodiment according to the invention, the top section 13 of the relief part is polymerized by exposing the relief layer 11 from the top side 20 of the plate 1. As an advantage, the upper part of the top section 13 can be determined relatively accurately, thereby providing a high resolution relief pattern. In this respect it is noted that the upper part of the top section 13 performs the printing action and that its location is therefore highly relevant for the printing quality. Further, from an energetic point of view, it is more attractive to irradiate the relief layer 11 from both the top side and the bottom side, respectively, since the relief layer 11 is lossy and the radiation intensity decays exponentially during penetration. A relief part is shown on the right hand side of Fig. 3 can thus be obtained. In order to enable radiation from both the top side and the bottom side, the receiving unit of the processing apparatus can include a pivoting mechanism for rotating the flexographic plate over 180°. Alternatively, the optical system of the apparatus is arranged for generating laser beams entering the relief layer 11 from opposite sides, e.g. by using two laser devices or by suitably splitting a laser beam and optically directing the beams separately to the top side 20 and the bottom side 25, respectively.

Alternatively, the entire relief part is polymerized by exposure from the back side, via the ground layer. In this way, the optical system and/or the receiving unit of the processing apparatus 4 can be implemented in a more simple way. Optionally, a radiation reflection surface 21 is applied on the top surface 20 of the plate 1 to improve the smoothness of the top section's 13 side surface.

The relief parts 12 can be polymerized by subsequently forming layers extending in a lateral direction L. As an example, a first top section 13b can be polymerized on top of the supporting section 15, while at a later stage, a second top section 13a can be polymerized reaching the top surface 20 of the relief layer 11. In this process, the optical system can be arranged to redirect the laser beam or the multiple number of sub laser beams stepwise, such that a polymerized part of the total area, when seen in a top view, is connected to a newly irradiated part. The (sub) laser beam can thus be redirected stepwise or continuously in all lateral directions L until the whole area to be irradiated, when seen in a top view, is covered. A single pass has been performed. Then, a layer of the relief pattern parts can be formed. During a time period wherein no beam redirection occurs, the laser beam can be modulated in power and/or time, optionally using the control mechanism of the micro mirrors in the DMD, as described above. The whole process of processing the entire area to be processed can be repeated for polymerizing a multiple number of layers that may have mutually different lateral extensions, so that a real 3D structure can be generated in a multi-pass scheme. Alternatively, the entire area to be processed, when seen in a top view, is scanned in one pass, thus polymerizing the relief parts from bottom to top in a single polymerization growth phase.

Preferably, the lateral dimension w' of a stiffening section 16b is in the order of the height of the corresponding relief part 2b. As an example, the ratio of the width w' of a stiffening section with respect to a relief part height can be circa 0.5, 1, 2, 4 or 10, thereby contributing to a solid relief pattern.

It is noted that the lateral direction L can be any direction that is parallel to the plane wherein the ground layer 10 extends, and that is transverse to the height direction H. The relief part may have any geometry when seen in a direction towards the ground layer, e.g. a square, a circle, an ellipse or a polygon.

After the polymerization process has ended, the non-polymerized material 22, 23 is removed in a washing process.

As shown on the right hand side of Fig. 3 stiffening sections 16c,d,e located between adjacent protruding relief parts can be integrated, such that a minimum relief depth R is obtained. Here, the relief depth R is defined as the minimum height of the stiffening section between adjacent relief parts. In the shown embodiment, the supporting section 15, 15' is stabilized by an intermediate stiffening section 16c-e having a truncated downwardly tapered upper surface 19 having two bevelled surfaces 16c,d mutually connected via an intermediate surface 18 extending in the lateral directions.

Apparently, the relief depth R can be set in dependence of a lateral resolution of the relief pattern.

Figure 4 shows a flow chart of an embodiment of the method according to the invention. The method is used for processing flexographic plates. The method comprises the step of providing 110 a flexographic plate including a relief layer containing a photosensitive material. Further, the method comprises the step of locally exposing 120 the relief layer to a laser beam for polymerizing a relief pattern in the layer, the relief pattern being constituted by a multiple number of relief parts upwardly protruding from a ground layer, wherein a protruding relief part includes a top section and a basis section having a supporting section supporting the top section, and a stiffening section extending from the supporting section in a lateral direction

The method of processing flexographic plates can be executed using dedicated hardware structures, such as FPGA and/or ASIC components. Otherwise, the method can also at least partially be performed using a computer program product comprising instructions for causing a processor of a computer system or a control unit to perform the above described steps of the method according to the invention. All (sub)steps can in principle be performed on a single processor. However, it is noted that at least one step can be performed on a separate processor, e.g. the step of locally exposing the relief layer to a laser beam.

In this context, it is noted that control data for controlling the imaging process include data associated with the location of the relief part top sections and data associated with the location of the relief part basis sections. Apparently the basis sections data is related to the top sections data since the basis sections support and stiffen the corresponding top sections. Therefore, imaging the basis sections via the back side of the flexographic plate is depending on top sections data relating to the printing patterns.

The invention is not restricted to the embodiments described herein. It will be understood that many variants are possible.

A number of further processing steps can be performed, e.g. a step of post illuminating the relief pattern.

Other such variants will be apparent for the person skilled in the art and are considered to fall within the scope of the invention as defined in the following claims.

## Claims

1. A processing apparatus (4) for processing a flexographic plate (1), comprising a receiving unit for receiving a flexographic plate including a relief layer (11) containing a photosensitive material, and an optical system for locally exposing the relief layer, wherein the optical system includes an illumination system for generating an optical beam (B) and an imaging system (7) for directing the beam towards the relief layer for polymerizing a relief pattern in the layer, the relief pattern being constituted by a multiple number of relief parts (12b, 12c) upwardly protruding from a ground layer (10), wherein a protruding relief part includes a top section (13) and a basis section (14) having a supporting section (15) supporting the top section, and a stiffening section (16a, 16b) extending from the supporting section in a lateral direction, wherein the imaging system is arranged for directing the optical beam towards the relief layer via the ground layer for polymerizing the basis section of the relief part, wherein the illumination system includes a laser device (6) arranged for exposing the relief layer via a top side (20) of the plate, via the ground layer, via both the top side and the ground layer, respectively, after splitting the optical laser beam, or wherein the illumination system includes two laser devices for generating laser beams entering the relief layer via the top side and the ground layer, respectively, for polymerizing the top section of the protruding relief part having vertical side walls.

2. A processing apparatus according to claim 1, wherein the optical system further includes a control unit (24) for controlling the optical beam.

3. A processing apparatus according to any of the preceding claims 1-2, wherein the control unit is arranged for controlling the optical beam such that the upwardly protruding relief part has a beveled side surface.

4. A processing apparatus according to any of the preceding claims 1-3, wherein the control unit is arranged for controlling the optical beam such that the top section has a side that is oriented mainly transverse with respect to the ground layer.

5. A processing apparatus according to any of the preceding claims 1-4, wherein the optical system is arranged for exposing the relief layer from a top side and from a bottom side.

6. A method for processing flexographic plates, comprising the steps of:
- providing a flexographic plate (1) including a relief layer (11) containing a photosensitive material, and
- locally exposing the relief layer to an optical beam (B) of a laser device (6) for polymerizing a relief pattern in the layer, the relief pattern being constituted by a multiple number of relief parts (12b, 12c) upwardly protruding from a ground layer (10), wherein a protruding relief part includes a top section (13) and a basis section (14) having a supporting section (15) supporting the top section, and a stiffening section (16a, 16b) extending from the supporting section in a lateral direction,
wherein the basis section of the relief part is polymerized by directing the optical beam towards the relief layer via the ground layer, and wherein the top section of the protruding relief part having vertical side walls is polymerized by directing the optical laser beam towards the relief layer via the top side, via the ground layer, via both the top side and the ground layer, respectively, after splitting the optical laser beam, or by using two laser devices for generating laser beams entering the relief layer via the top side and the ground layer.

7. A method according to claim 6, wherein the top section is polymerized by exposing the relief layer from the top side of the plate.

8. A method according to claim 6, wherein the entire relief part is polymerized by exposure through the ground layer.

9. A method according to claim 8, wherein, during polymerizing the top section, a radiation reflection surface is applied on top of the plate.

10. A method according to any of the preceding claims 6-9, wherein the wavelength of the optical beam is about 405 nm.

11. A method according to any of the preceding claims 6-10, further including modulating the optical beam in power and/or time.

12. A method according to any of the preceding claims 6-11, wherein the relief part is polymerized by subsequently forming layers extending in a lateral direction.

13. A method according to any of the preceding claims 6-12, wherein a lateral dimension of a stiffening section is in the order of the height of the corresponding relief part.

14. A method according to any of the preceding claims 6-13, wherein stiffening sections between adjacent protruding relief parts are integrated and have a relief depth exceeding a minimum level.

15. A computer program product for processing flexographic plates, the computer program product comprising computer readable code for causing a processor to perform the step of locally exposing the relief layer (11) of a flexographic plate (1) to an optical beam (B) of a laser device (6) for polymerizing a relief pattern in the layer, the relief pattern being constituted by a multiple number of relief parts (12b, 12c) upwardly protruding from a ground layer (10), wherein a protruding relief part includes a top section (13) and a basis section (14) having a supporting section (15) supporting the top section, and a stiffening section (16a, 16b) extending from the supporting section in a lateral direction, wherein the top section of the protruding relief part has vertical side walls that are polymerized by directing the optical laser beam towards the relief layer via the top side, via the ground layer, via both the top side and the ground layer, respectively, after splitting the optical laser beam, or by using two laser devices for generating laser beams entering the relief layer via the top side and the ground layer.

## Patentansprüche

1. Eine Bearbeitungsvorrichtung (4) zum Bearbeiten einer flexographischen Platte (1), aufweisend
eine Aufnahmeeinheit zum Aufnehmen einer flexographischen Platte mit einer Reliefschicht (11), die ein lichtempfindliches Material enthält, und ein optisches System zum lokalen Belichten der Reliefschicht, wobei das optische System ein Beleuchtungssystem zum Erzeugen eines optischen Strahls (B) und ein Abbildungssystem (7) zum Ausrichten des Strahls auf die Reliefschicht zum Polymerisieren eines Reliefmusters in der Schicht aufweist, wobei das Reliefmuster durch eine Mehrzahl von Reliefteilen (12b, 12c) gebildet wird, die von einer Grundschicht (10) nach oben vorstehen, wobei ein vorstehendes Reliefteil einen oberen Abschnitt (13) und einen Basisabschnitt (14) mit einem den oberen Abschnitt stützenden Stützabschnitt (15) und einen sich von dem Stützabschnitt in einer seitlichen Richtung erstreckenden Versteifungsabschnitt (16a, 16b) aufweist, wobei das Abbildungssystem zum Ausrichten des optischen Strahls auf die Reliefschicht über die Grundschicht zum Polymerisieren des Basisabschnitts des Reliefteils ausgebildet ist, wobei das Beleuchtungssystem eine Laservorrichtung (6) aufweist, die ausgebildet ist, um die Reliefschicht über eine Oberseite (20) der Platte, über die Grundschicht oder sowohl über die Oberseite als auch über die Grundschicht zu belichten, nachdem der optische Laserstrahl geteilt wurde, oder wobei das Beleuchtungssystem zwei Laservorrichtungen aufweist, um Laserstrahlen zu erzeugen, welche in die Reliefschicht über die Oberseite bzw. die Grundschicht eintreten, um den oberen Abschnitt des vorstehenden Reliefteils mit vertikalen Seitenwänden zu polymerisieren.

2. Bearbeitungsvorrichtung nach Anspruch 1, wobei das optische System ferner eine Steuereinheit (24) zur Steuerung des optischen Strahls aufweist.

3. Bearbeitungsvorrichtung nach einem der vorherigen Ansprüche 1 bis 2, wobei die Steuereinheit dazu ausgebildet ist, den optischen Strahl so zu steuern, dass das nach oben vorstehende Reliefteil eine abgeschrägte Seitenfläche aufweist.

4. Bearbeitungsvorrichtung nach einem der vorherigen Ansprüche 1 bis 3, wobei die Steuereinheit dazu ausgebildet ist, den optischen Strahl so zu steuern, dass der obere Abschnitt eine Seite aufweist, die hauptsächlich quer zur Grundschicht ausgerichtet ist.

5. Bearbeitungsvorrichtung nach einem der vorhergehenden Ansprüche 1 bis 4, wobei das optische System zur Belichtung der Reliefschicht über eine Oberseite und über eine Unterseite ausgebildet ist.

6. Verfahren zum Bearbeiten von flexographischen Platten, aufweisend die folgenden Schritte:
- Bereitstellen einer flexographischen Platte (1) mit einer Reliefschicht (11), die ein lichtempfindliches Material enthält, und
- lokales Belichten der Reliefschicht mit einem optischen Strahl (B) einer Laservorrichtung (6) zum Polymerisieren eines Reliefmusters in der Schicht, wobei das Reliefmuster durch eine Mehrzahl an Reliefteilen (12b, 12c) gebildet wird, die von einer Grundschicht (10) nach oben vorstehen, wobei ein vorstehendes Reliefteil einen oberen Abschnitt (13) und einen Basisabschnitt (14) mit einem den oberen Abschnitt stützenden Stützabschnitt (15) und einen sich von dem Stützabschnitt in einer seitlichen Richtung erstreckenden Versteifungsabschnitt (16a, 16b) aufweist, wobei der Basisabschnitt des Reliefteils polymerisiert wird, indem der optische Strahl über die Grundschicht auf die Reliefschicht ausgerichtet wird und wobei der obere Abschnitt des vorstehenden Reliefteils mit vertikalen Seitenwänden polymerisiert wird, indem der optische Laserstrahl auf die Reliefschicht über die Oberseite, über die Grundschicht oder sowohl über die Oberseite als auch über die Grundschicht ausgerichtet wird, nachdem der optische Laserstrahl geteilt wurde, oder indem zwei Laservorrichtungen zum Erzeugen von Laserstrahlen verwendet werden, welche über die Oberseite und die Grundschicht in die Reliefschicht eintreten.

7. Verfahren nach Anspruch 6, wobei der obere Abschnitt durch Belichten der Reliefschicht von der Oberseite der Platte aus polymerisiert wird.

8. Verfahren nach Anspruch 6, wobei der gesamte Reliefteil durch Belichten über die Grundschicht polymerisiert wird.

9. Verfahren nach Anspruch 8, wobei während der Polymerisation des oberen Abschnitts eine strahlungsreflektierende Oberfläche auf die Platte aufgebracht wird.

10. Verfahren nach einem der vorherigen Ansprüche 6 bis 9, wobei die Wellenlänge des optischen Strahls etwa 405 nm beträgt.

11. Verfahren nach einem der vorherigen Ansprüche 6 bis 10, das ferner die Modulation des optischen Strahls hinsichtlich Leistung und/oder Zeit beinhaltet.

12. Verfahren nach einem der vorherigen Ansprüche 6 bis 11, wobei der Reliefteil durch anschließendes Bilden von in lateraler Richtung verlaufenden Schichten polymerisiert wird.

13. Verfahren nach einem der vorherigen Ansprüche 6 bis 12, wobei eine seitliche Erstreckung eines Versteifungsabschnitts in der Größenordnung der Höhe des entsprechenden Reliefsteils liegt.

14. Verfahren nach einem der vorherigen Ansprüche 6 bis 13, wobei zwischen benachbarten vorstehenden Reliefteilen Versteifungsabschnitte ausgebildet sind die eine Relieftiefe aufweisen, die über einem Mindestniveau liegt.

15. Computerprogrammprodukt zum Bearbeiten von flexographischen Platten, wobei das Computerprogrammprodukt einen computerlesbaren Code umfasst, um einen Prozessor zu veranlassen, den Schritt des lokalen Belichtens der Reliefschicht (11) einer flexographischen Platte (1) mit einem optischen Strahl (B) einer Laservorrichtung (6) zum Polymerisieren eines Reliefmusters in der Schicht durchzuführen, wobei das Reliefmuster durch eine Mehrzahl von Reliefteilen (12b, 12c) gebildet wird, die von einer Grundschicht (10) nach oben vorstehen, wobei ein vorstehendes Reliefteil einen oberen Abschnitt (13) und einen Basisabschnitt (14) mit einem Stützabschnitt (15), der den oberen Abschnitt stützt und einen Versteifungsabschnitt (16a, 16b) aufweist, der sich von dem Stützabschnitt in einer seitlichen Richtung erstreckt, wobei der obere Abschnitt des vorstehenden Reliefteils vertikale Seitenwände aufweist, die polymerisiert werden, indem der optische Laserstrahl auf die Reliefschicht über die Oberseite, über die Grundschicht oder über sowohl die Oberseite als auch die Grundschicht ausgerichtet wird, nachdem der optische Laserstrahl geteilt wurde, oder indem zwei Laservorrichtungen zum Erzeugen von Laserstrahlen verwendet werden, die in die Reliefschicht über die Oberseite und die Grundschicht eintreten.

## Revendications

1. Dispositif de traitement (4) destiné à traiter une plaque de flexographie (1), comprenant
une unité de réception destinée à recevoir une plaque de flexographie comportant une couche en relief (11) contenant un matériau photosensible et un dispositif optique destiné à exposer localement la couche en relief, dans lequel le dispositif optique comporte un dispositif d'éclairement destiné à produire un faisceau optique (B) et un dispositif d'imagerie (7) destiné à diriger le faisceau vers la couche en relief afin de polymériser un motif en relief dans la couche, le motif en relief étant constitué par un nombre multiple de parties en relief (12b, 12c) s'étendant vers le haut à partir d'une couche de fond (10),
dans lequel une partie saillante en relief comporte une section supérieure (13) et une section de base (14) comportant une section de support (15) supportant la section supérieure, et une section de renforcement (16a, 16b) s'étendant à partir de la section de support dans une direction latérale, dans lequel le dispositif d'imagerie est agencé afin de diriger le faisceau optique vers la couche en relief à travers la couche de fond afin de polymériser la section de base de la partie en relief, dans lequel le dispositif d'éclairement comporte un dispositif à laser (6) agencé afin d'exposer la couche en relief respectivement à travers une face supérieure (20) de la plaque, à travers la couche de fond, à la fois à travers la face supérieure et la couche de fond, après division du faisceau optique laser ou dans lequel le dispositif d'éclairement comporte deux dispositifs à laser afin de produire des faisceaux laser entrant dans la couche en relief respectivement à travers la face supérieure et la couche de fond, afin de polymériser la section supérieure de la partie saillante en relief comportant des parois latérales verticales.

2. Dispositif de traitement selon la revendication 1, dans lequel le dispositif optique comporte, en outre, une unité de commande (24) destinée à commander le faisceau optique.

3. Dispositif de traitement selon l'une quelconque des revendications 1 et 2 précédentes, dans lequel l'unité de commande est agencée afin de commander le faisceau optique de telle sorte que la partie en relief s'étendant vers le haut présente une surface latérale biseautée.

4. Dispositif de traitement selon l'une quelconque des revendications 1 à 3 précédentes, dans lequel l'unité de commande est agencée afin de commander le faisceau optique de telle sorte que la section supérieure présente une face qui est orientée principalement transversalement par rapport à la couche de fond.

5. Dispositif de traitement selon l'une quelconque des revendications 1 à 4 précédentes, dans lequel le dispositif optique est agencé afin d'exposer la couche en relief à partir d'une face supérieure et à partir d'une face inférieure.

6. Procédé de traitement de plaques de flexographie, comprenant les étapes de :
préparation d'une plaque de flexographie (1) comportant une couche en relief (11) contenant un matériau photosensible, et
exposition locale de la couche en relief à un faisceau optique (B) d'un dispositif à laser (6) afin de polymériser un motif en relief sur la couche, le motif en relief étant constitué par un nombre multiple de parties en relief (12b, 12c) s'étendant vers le haut à partir de la couche de fond (10),
dans lequel une partie saillante en relief comporte une section supérieure (13) et une section de base (14) comportant une section de support (15) supportant la section supérieure et une section de renforcement (16a, 16b) s'étendant à partir de la section de support dans une direction latérale,
dans lequel la section de base de la partie en relief est polymérisée en dirigeant le faisceau optique vers la couche en relief à travers la couche de fond, et dans lequel la section supérieure de la partie saillante en relief comportant des parois latérales verticales est polymérisée en dirigeant le faisceau optique laser vers la couche en relief respectivement à travers la face supérieure, à travers la couche de fond, à la fois à travers la face supérieure et la couche de fond, après division du faisceau optique laser, ou en utilisant deux dispositifs à laser afin de produire des faisceaux laser entrant dans la couche en relief à travers la face supérieure et la couche de fond.

7. Procédé selon la revendication 6, dans lequel la section supérieure est polymérisée en exposant la couche en relief à partir du face supérieure de la plaque.

8. Procédé selon la revendication 6, dans lequel la totalité de la partie en relief est polymérisée par exposition à travers la couche de fond.

9. Procédé selon la revendication 8, dans lequel, au cours de la polymérisation de la section supérieure, une surface réfléchissant le rayonnement est appliquée au dessus de la plaque.

10. Procédé selon l'une quelconque des revendications précédentes 6 à 9, dans lequel la longueur d'onde du faisceau optique est de 405 nm environ.

11. Procédé selon l'une quelconque des revendications 6 à 10 précédentes, comportant, en outre, la modulation du faisceau optique en puissance et/ou dans le temps.

12. Procédé selon l'une quelconque des revendications précédentes 6 à 11, dans lequel la partie en relief est polymérisée en formant successivement des couches s'étendant dans une direction latérale.

13. Procédé selon l'une quelconque des revendications précédentes 6 à 12, dans lequel une dimension latérale d'une section de renforcement est de l'ordre de la hauteur de la partie en relief correspondante.

14. Procédé selon l'une quelconque des revendications précédentes 6 à 13, dans lequel des sections de renforcement entre des parties saillantes en relief adjacentes sont intégrées et présentent une profondeur de relief excédant un niveau minimum.

15. Produit formant programme informatique destiné à traiter des plaques de flexographie, le produit formant programme informatique comprenant un code pouvant être lu par un ordinateur de manière à amener une unité de traitement à exécuter l'étape d'exposition locale de la couche en relief (11) d'une plaque de flexographie (1) à un faisceau optique (B) d'un dispositif à laser (6) afin de polymériser un motif en relief sur la couche, le motif en relief étant constitué par un nombre multiple de parties en relief (12b, 12c) s'étendant vers le haut à partir d'une couche de fond (10),
dans lequel une partie saillante en relief comporte une section supérieure (13) et une section de base (14) comportant une section de support (15) supportant la section supérieure, et une section de renforcement (16a, 16b) s'étendant à partir de la section de support dans une direction latérale, dans lequel la section supérieure de la partie saillante en relief comporte des parois latérales verticales qui sont polymérisées en dirigeant le faisceau optique laser vers la couche en relief respectivement à travers la face supérieure, à travers la couche de fond, à la fois à travers la face supérieure et la couche de fond, après division du faisceau optique laser, ou en utilisant deux dispositifs à laser afin de produire des faisceaux laser entrant sur la couche en relief à travers la face supérieure et la couche de fond.
